Europäisches Patentamt

European Patent Office

Office européen des brevets

(19)

(11) Publication number: **0 057 310**
**B1**

# EUROPEAN PATENT SPECIFICATION

(12)

(45) Date of publication of patent specification: **06.05.87**

(51) Int. Cl.⁴: **G 11 C 19/08**

(21) Application number: **81304728.9**

(22) Date of filing: **12.10.81**

(54) Bubble memory devices.

(30) Priority: **03.02.81 JP 14756/80**

(43) Date of publication of application:
**11.08.82 Bulletin 82/32**

(45) Publication of the grant of the patent:
**06.05.87 Bulletin 87/19**

(84) Designated Contracting States:
**DE FR GB**

(56) References cited:
**US-A-4 145 750**

(73) Proprietor: **FUJITSU LIMITED**
**1015, Kamikodanaka Nakahara-ku**
**Kawasaki-shi Kanagawa 211 (JP)**

(72) Inventor: **Takai, Sakan**
**397-9, Sakata-cho**
**Suzaka-shi Nagano 382 (JP)**
Inventor: **Sukeda, Toshiaki**
**406-3, Sakata-cho**
**Suzaka-shi Nagano 382 (JP)**

(74) Representative: **Sunderland, James Harry et al**
**HASELTINE LAKE & CO Hazlitt House**
**28 Southampton Buildings Chancery Lane**
**London WC2A 1AT (GB)**

EP 0 057 310 B1

Courier Press, Leamington Spa, England.

## Description

This invention relates to magnetic bubble memory devices.

When an adequate bias field is applied vertically to a surface of a thin magnetic plate, of garnet or orthoferrite, for example, having uniaxial magnetic anisotropy, a cylindrical magnetic domain, a so-called magnetic bubble, is generated.

A magnetic bubble device which performs accumulation of information and logical operations, by making use of such magnetic bubbles, is being developed for practical use because such a device is non-volatile, fully solid state, suitable for large capacity memory use, and operates at a comparatively high speed.

For a magnetic bubble device, various functions such as generation, transfer, division, expansion, detection and erasure (annihilation of magnetic bubbles are required. Moreover, there are also required bias field application means for stably maintaining a magnetic bubble in the thin magnetic plate of the device, and rotating field application means for moving a magnetic bubble in the thin magnetic plate in dependence upon a magnetic pattern formed on the thin magnetic plate.

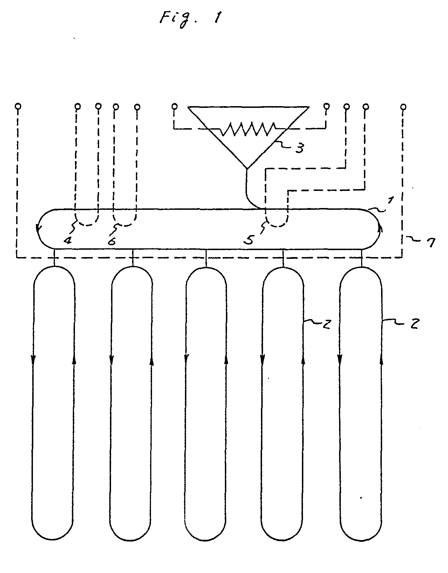

Figure 1 of the accompanying drawings schematically illustrates an example of a typical structure of a magnetic bubble memory chip used for a magnetic bubble device.

The structure of Figure 1 is a so-called major-minor loop structure.

In Figure 1, 1 is the major loop, 2 indicates minor loops, 3 is a detector, 4 is a generator, 5 is a replicator, 6 is an annihilator, and 7 is a transfer gate. Solid lines in Figure 1 indicate magnetic bubble transfer routes of a permalloy pattern formed on the magnetic bubble thin plate, whilst the broken lines indicate a conductor pattern, of gold for example, formed on the thin plate. Operations are explained below.

A current is applied, in such a direction as effectively to reduce the bias field, to the loop of the conductor pattern forming the generator 4, in accordance with data to be written, in order to generate a magnetic bubble within the said loop. The magnetic bubble which is generated is transferred around the major loop 1 by the drive field, which rotates within the surface direction of the thin magnetic film. For example, bubbles representing one data item (as much as one word, for example) are arranged respectively at positions corresponding to respective minor loops 2. At this time, a current is applied to the conductor pattern forming the transfer gate 7 and the magnetic bubbles of the magnetic bubble group on the major loop 1 are transferred to the minor loops 2. Magnetic bubbles transferred to the minor loops 2 circulate in the minor loops 2 by means of the drive field, thus storing data in the device.

The stored data can be read as follows. Namely, when a magnetic bubble group to be read (the bubbles of which are in the minor loops 2) comes to a position corresponding to the transfer gate 7 (e.g. the bubbles of the group in the minor loops are in positions corresponding to the transfer gate), a current is applied to the conductor pattern and thereby the magnetic bubble group is transferred from the minor loops to the major loop 1. The magnetic bubble train transferred to the major loop is sequentially transferred to the replicator 5 by means of the drive field. The replicator 5 divides incoming magnetic bubbles into two parts and transfers one part to the detector 3 along the permalloy pattern, whilst the other part is returned to the minor loops again, via the major loop 1. The detector 3 expands magnetic bubbles sequentially appearing thereat, in order to raise detection efficiency, and reads a change in electrical resistance of a magnetic resistance element resulting from the incoming of a bubble as a change of voltage. When it is required to erase data after reading thereof, and to write new data, it is necessary to erase magnetic bubbles, after division, by means of the annihilator 6 on the major loop and to send in new data by means of generator 4.

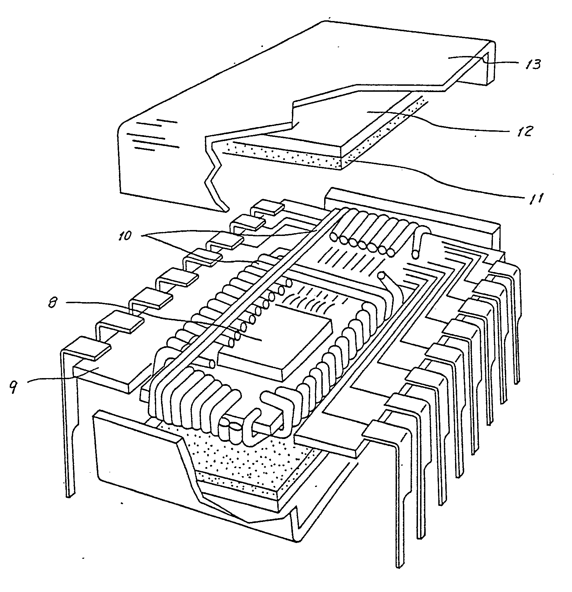

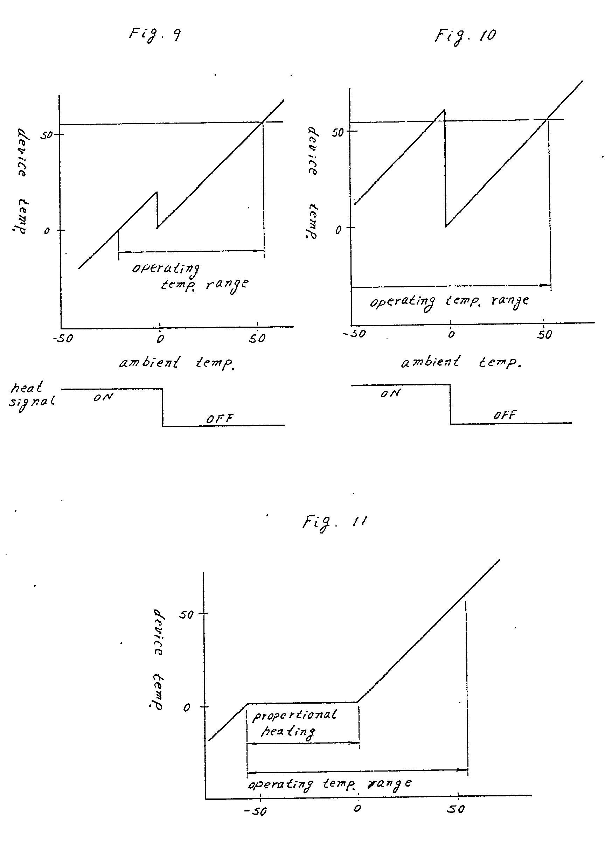

Figure 2 of the accompanying drawings is a schematic exploded perspective view of the structure of a package accommodating a magnetic bubble chip as shown in Figure 1. In Figure 2, 8 is the magnetic bubble chip, 9 is a chip mounting plane, 10 indicates XY coils for drivefield generation, 11 is a ferrite yoke, 12 is a thin plate magnet for applying bias field, and 13 is a shield case.

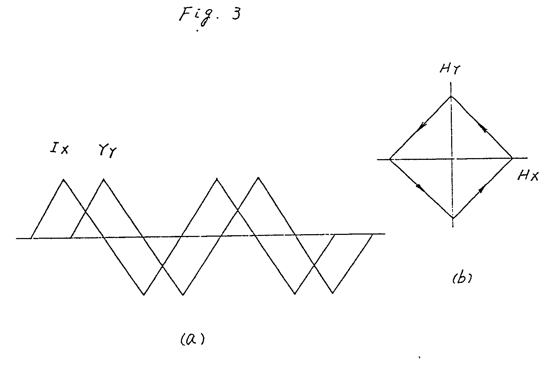

Triangular currents having a phase difference of 90° as shown in waveform (a) of Figure 3 of the accompanying drawings are applied to each of the XY coils for drive field generation and a square locus rotating field as shown graphically at (b) in Figure 3 of the accompanying drawings can be obtained. Such a drive method using triangular waveform currents has various advantages as compared with a drive method using sine wave currents. For example, circuit structure is simplified, fewer parts are used, high drive voltage is not required, and integration can be realised easily.

The storage operation of a magnetic bubble memory as explained above is stable within an operating temperature range determined by the temperature characteristic of domain crystal in the magnetic thin film, but such range is comparatively narrow, for example 0°C to +55°C in existing examples. However, in practice, a memory is required which can operate over the temperature range −20°C to +55°C. At present, devices which can satisfy this requirement for operation over such temperature range are obtained simply by selection from many devices.

Therefore, at present, a selection step is necessary in order to obtain devices offering the required wide temperature range. This clearly has a degrading effect on the yield of usable devices.

US—A—4 145 750 discloses in connection with a magnetic bubble memory device that, with a view to preventing decreased bias field margin at a start/stop operation, current may flow in an in-plane field drive coil during a transient stop operation and even during an interrupted state of the device, when rotation of the in-plane field has stopped.

According to the present invention there is provided a method of driving a magnetic bubble memory device having a rotating-field generation coil operable to apply a rotating field to a magnetic pattern formed on a magnetic bubble memory chip of the device for transferring a magnetic bubble along the magnetic pattern, characterised in that a heating current, for heating the chip, is applied to the rotating-field generation coil in dependence upon temperature output data obtained from temperature detection means, in a period in which magnetic bubble transfer control is not being performed.

According to the present invention there is provided a magnetic bubble memory device, having a rotating-field generation coil operable to apply a rotating field to a magnetic pattern formed on a magnetic bubble memory chip of the device for transferring a magnetic bubble along the magnetic pattern, characterised by temperature detection means operable to provide temperature output data, and means operable to apply a heating current, for heating the chip, to the rotating field generation coil in dependence upon the said temperature output data, in a period in which magnetic bubble transfer control is not being performed.

An embodiment of the present invention can provide a bubble memory device having a wider operating temperature range than previously proposed devices.

An embodiment of the present invention can provide a small size magnetic bubble memory device in which a rotating-field generation coil functions also as heating means.

A magnetic bubble memory device embodying the present invention comprises a rotating-field generation coil for applying a rotating field to a magnetic pattern formed on a magnetic bubble memory chip and for transferring a magnetic bubble along the magnetic pattern, and operation of the device over a relatively wide temperature range is assured by providing that the chip can be heated by applying a heating current to the rotating-field generation coil in a period in which magnetic bubble transfer control is not being carried out.

In a magnetic bubble memory device embodying the present invention, a rotating-field generation coil is also used as heating means by providing for the application thereto of a heating current during a period in which the coil is not used for fundamental operations, that is, when no access is being made to the magnetic bubble memory device. A magnetic bubble is transferred along the magnetic pattern magnetised by the rotating field, but when the rotating field disappears, a hold field is applied in a constant direction of this magnetic pattern in order to hold the magnetic bubble at a constant location in the magnetic pattern.

Reference is made, by way of example, to the accompanying drawings, in which:—

Figure 1 schematically illustrates a typical structure of a magnetic bubble memory chip,

Figure 2 is a schematic exploded perspective view of the structure of a package for accommodating a magnetic bubble memory chip,

Figure 3, (a) is a graphical representation of a rotating field generation coil drive signal waveform, and (b) is a graphical representation of a magnetic field generated by the waveform of (a),

Figures 4 and 5 are schematic diagrams for assisting in explanation of the principle of a hold magnetic field,

Figure 6 illustrates an equivalent circuit of a Y coil,

Figure 7 is a graphical representation illustrating drive current margins of X and Y coils,

Figure 8 is a schematic block diagram of a rotating field generation coil drive circuit of a magnetic bubble memory device embodying the present invention,

Figures 9, 10 and 11 are respective graphical representations for assistance in explanation of how operating temperature range is widened by means of the present invention,

Figure 12 schematically illustrates an example of temperature changes in a device embodying the present invention,

Figure 13 is a schematic block diagram of a rotating field generation coil drive circuit of another magnetic bubble memory device embodying the present invention,

Figure 14 is a waveform diagram illustrating timing of heating signals applied in operation of the circuit of Figure 13,

Figure 15 is a circuit diagram of a triangular wave drive circuit for a Y rotating field generation coil of an embodiment of the present invention.

Figure 16 is a waveform diagram illustrating operational timing in the circuit of Figure 15,

Figure 17 is a circuit diagram of another triangular wave drive circuit for a Y rotating field generation coil of another embodiment of the present invention, and

Figure 18 is a waveform diagram illustrating operational timing in the circuit of Figure 17.

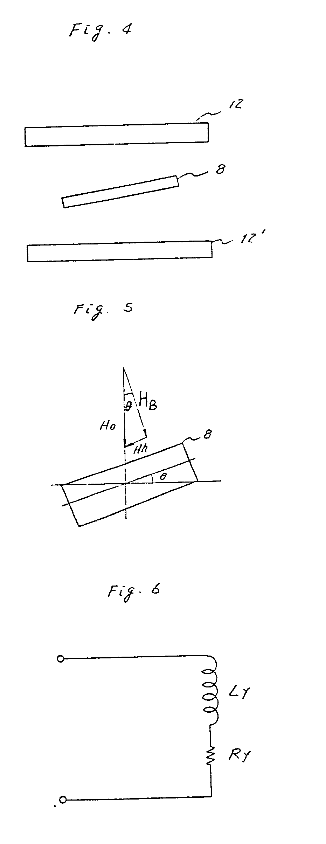

A hold field as mentioned above can be generated by various means. For example, as illustrated in Figure 4, a part of a bias field may be used. Here, a magnetic bubble chip 8 is placed at a slant angle $\theta$ in a field $H_o$ of bias field application magnetics 12, 12'. In such an arrangement, a bias field $H_B$ and a horizontal field $H_h$ are generated on the bubble chip, as illustrated in Figure 5. At this time, the horizontal field $H_h$ alone is used as hold magnetic field. In an embodiment of the present invention, a heating current can be applied to the rotating field generation coil when access is not being made to the magnetic bubble device and naturally the direction of field generated by the heating current flowing into the coil at this time should preferably coincide with the direction of the hold magnetic field. Therefore, explanation will be given below in relation to a case in which a heating current is applied to a Y coil only.

Figure 6 shows an equivalent circuit of a Y coil. $L_Y$ is coil inductance and $R_Y$ is DC coil resistance.

When a current $L_Y$ flows into the coil, the power P consumed by the coil is expressed as follows:—

$$P = I^2_Y R_Y.$$

When the temperature rise of the device per power consumption (W) is taken to be T°C/W, a current $I_Y$ for raising device temperature by t°C can be expressed as follows:—

$$I_Y = \sqrt{t/(T \cdot R_Y)} \qquad (A)$$

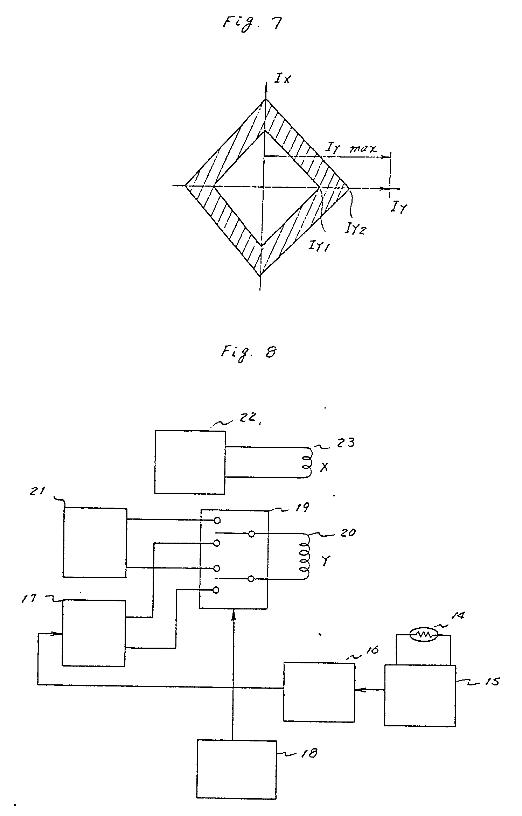

Figure 7 graphically illustrates drive current margins of X and Y coils. In ordinary operation, a current within the range indicated by hatching is used. The allowable maximum current $I_{Y\,max}$ in the hold direction which can be applied to the Y coil is determined by the maximum intensity of field in the hold direction which can stably hold a bubble in the magnetic pattern and the value of this maximum current differs for different devices but is generally within the range from $1.2 \times I_{Y2}$ to $2.0 \times I_{Y2}$.

Figure 8 is a block diagram of a rotating field generation coil drive circuit of a magnetic bubble memory device embodying the present invention. Circuit operation will be explained below.

An output of a temperature detecting element 14, such as a thermistor for example, is converted into a temperature detection signal by a temperature detector 15 and then transmitted to a driver control circuit 16 for heating. The driver control circuit 16 for heating changes the condition under which a heating driver 17 is driven in dependence upon the temperature detection signal. A change-over control circuit 18 controls a switch circuit 19 which connects a Y coil 20 and a Y coil driver 21 during a magnetic bubble access period, or connects the Y coil 20 and heating driver 17 for heating during other periods.

An X coil 23 is driven by an X coil driver 22 during a bubble access period.

Figures 9 and 10 show respective graphs for assistance in explanation of how operating temperature range of a magnetic bubble memory device can be broadened by the provision of heating means in accordance with an embodiment of the present invention.

The heating driver is operated when the ambient temperature is 0°C or less.

In Figure 9, a case is illustrated in which a heating current is applied such that maximum device temperature under heating is limited to about 20°C and the device can be used in the ambient temperature range from −20°C to +55°C. when the "basic" operating temperature range of the device (without heating) is 0°C to +55°C.

In Figure 10, a case is illustrated in which a higher heating current is used. In this case, the operating range of the magnetic bubble device is extended to lower temperatures, but device temperature may exceed +55°C at an ambient temperature of 0°C.

A device temperature in excess of +55°C can have an adverse effect on the device itself, and may mean that normal operation is not assured and may involve increasing power loss. Therefore, such a high device temperature should be avoided.

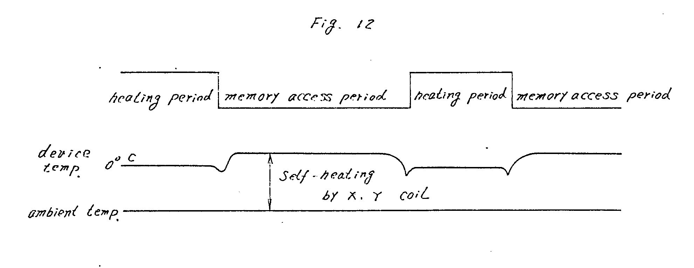

For this purpose, as illustrated graphically in Figure 11, for example, proportional heating can effectively be employed. In such proportional heating, the heating condition is changed so that appropriate heating at a temperature near to 0°C and at a temperature far from 0°C, under 0°C, can be applied.

For example, heating current applied may be proportional to the difference between the temperature detected by temperature detection means (e.g. 14), and the lowest permitted device operating temperature.

For example, heating current drive pulse width may be controlled in dependence upon temperature.

Heating current drive pulse period may be varied in dependence upon temperature.

Heating current value may be varied in dependence upon temperature.

A combination of factors, for example, as mentioned above, may be varied in dependence upon temperatures.

For example, practically, a high heating current is used, for example, at the ambient temperature of about −50°C and it is gradually decreased as temperature approaches 0°C by varying drive pulse width.

Figure 12 is illustrative of device temperature change of a magnetic bubble device embodying the present invention over a bubble memory access period and a heating period. When ambient temperature is low, a coil generates heat in the heating period. Therefore, the device is preheated and normal operation can be assured during a bubble memory access period.

In a bubble memory access period, temperature further increases by self-heating because current flows into both X and Y coils.

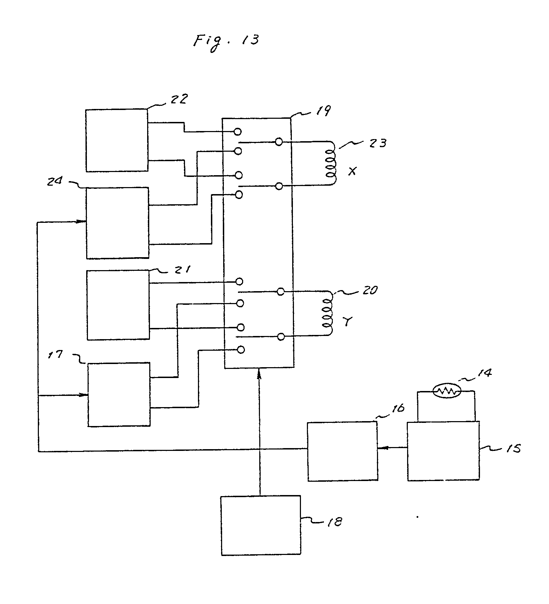

Figure 13 is a schematic block diagram of a rotating field generation coil drive circuit of another magnetic bubble memory device embodying the present invention.

In the first embodiment explained above, only the Y coil 20 is used for heating in the coil drive circuit block diagram, because field direction of the Y-coil 20 matches hold field direction. However, it is sometimes impossible to allow a high level current to flow into the Y coil 20 (depending upon device characteristics). In such a case, the X coil 23 may also be used for heating because the heating power obtained by using the Y coil 20 alone may be insufficient. In this case, the Y coil 20 and Y coil heating driver 17 are connected (by action of the change-over control circuit 18) in the heating period, whilst the X coil 23 and a X coil heating driver 24 are simultaneously connected, by the switch circuit 19.

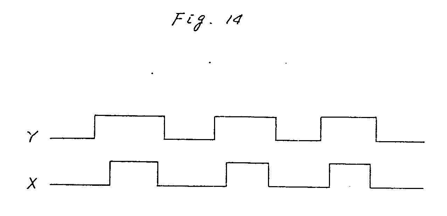

In this case, drive signals applied to the X coil 23 and Y coil 20 have timings as shown in Figure 14.

Namely, a signal is applied to the Y coil 20 and then a signal is applied also to the X coil 23, and after the signal applied to the X coil 23 has been disconnected the signal applied to the Y coil 20 is disconneted.

The generated field is centrally oriented (directed at 45°) between the X and Y directions when the signals of X coil 23 and Y coil 20 overlap but bubbles never depart from a stationary condition.

A more detailed practical example of a Y coil drive circuit as illustrated in Figure 8 will be explained below.

Figure 15 illustrates a triangular wave drive circuit for rotating field generation Y coil of an embodiment of the present invention. Figure 16 is an operational time chart for the circuit of Figure 15.

During a bubble memory access period, an ordinary triangular wave current flows into the Y coil 20. When a timing signal T1 is applied, this signal turns ON a transistor Q1 via a level conversion circuit M1. Simultaneously, a timing signal T4 is applied, and this signal turns ON a transistor Q4 via a level conversion circuit M4. Therefore, power supply V is, during the period of timing signals T1 and T4, connected to Y coil 20. Thereby a current $I_Y$ flows in the direction indicated by an arrow in Figure 15 in the Y coil 20. When the timing signals T1 and T4 disappear, a reverse current flows into the Y coil 20 via diodes D1 and D2 (D4).

Then, a timing signal T2 turns ON a transistor Q2 via the level conversion circuit M2 and simultaneously a timing signal T3 turns ON a transistor Q3 via a level conversion circuit M3. Thereby, a current flows into the Y coil 20 in a direction opposite to that indicated by the arrow in Figure 15. In this way, a triangular current flows into the Y coil when the timing signals T1, T4 and timing signals T2, T3 are applied alternately.

The above operations are performed during an ordinary bubble memory access period, but when a heating period starts continuous signals are applied to transistors Q5 and Q6 (Q2). As a result, during this period, the transistors Q2 and Q5 turn ON and the power source V is connected to the Y coil 20, and a current determined by the resistor r1 (Y1) and Y coil resistance $R_Y$ flows, causing generation of heat.

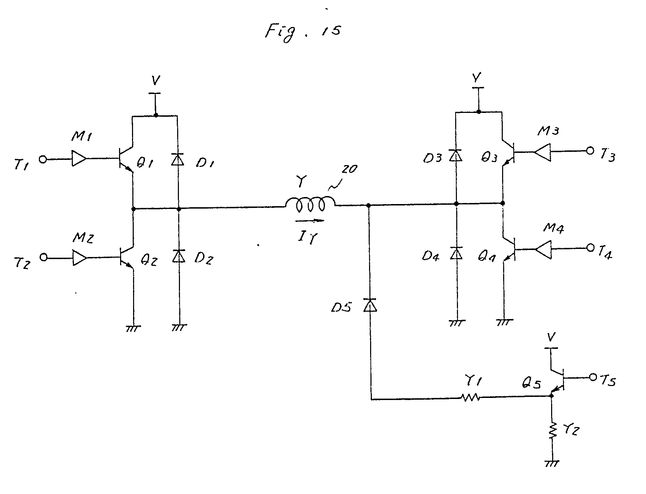

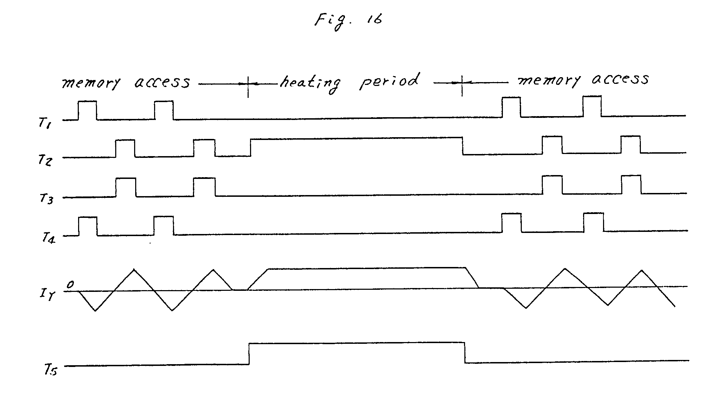

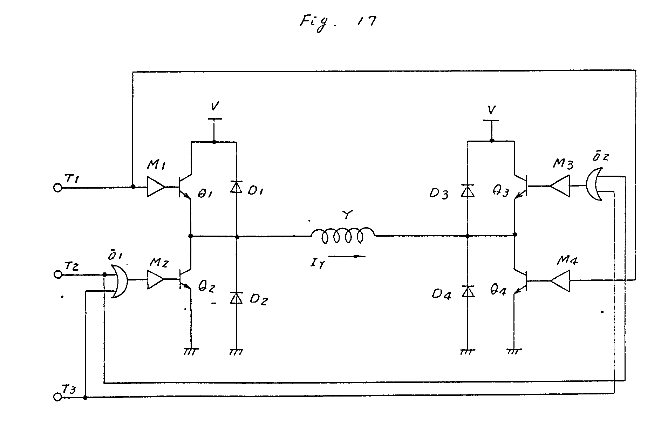

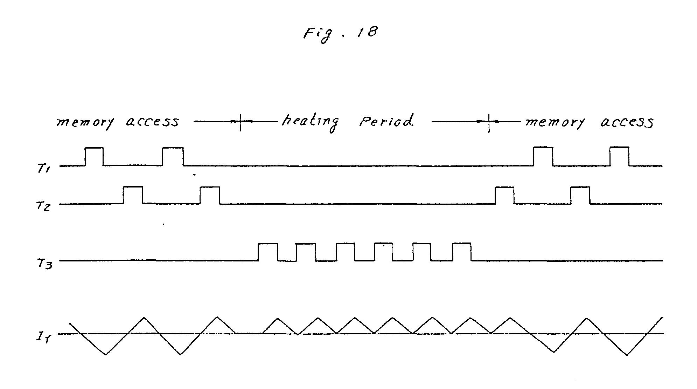

Figure 17 illustrates a Y coil triangular wave drive circuit of the Y coil of another embodiment of the present invention. Figure 18 is an operational time chart of the circuit of Figure 17.

In the circuit of Figure 17, control is simplified as compared with the circuit of Figure 15. Namely, when a timing signal T1 is applied in a bubble memory access period, this signal is applied to transistors Q1 and Q4 via level conversion circuits M1 and M4 turning ON both transistors simultaneously. As a result, a current $I_Y$ flows in the direction indicated by the arrow in Figure 17 into the Y coil 20. When a timing signal T2 is applied, this signal turns ON the transistor Q2 via OR circuit 01 and level conversion circuit M2. Simultaneously, this signal turns ON transistor Q3 via OR circuit 02 and level conversion circuit M3.

Therefore, a reverse current flows to the Y coil. A triangular wave current is caused to flow by repeating such operations.

The above operations are performed during a bubble memory access period, and when a heating period begins, only a timing signal T3 is applied.

Whilst the timing signal T3 is ON, the transistors Q2 and Q3 become ON and a current flows into the Y coil 20. Since the period of timing signals T3 is shorter than that of timing signals T1 or T2 (see Figure 18), heat is gradually generated. Heat radiation of the Y coil 20 is controlled by adjusting the period of the timing signals T3, or the pulse width of timing signals T3.

As explained above, an embodiment of the present invention can provide a significant improvement in the operating temperature range of a magnetic bubble memory device by arranging for heating current to be applied to a rotating field generation coil during a period in which no access is being performed to the magnetic bubble memory.

An embodiment of the present invention provides a magnetic bubble memory device which comprises a rotating field generation coil for applying a rotating field to a magnetic pattern formed on a magnetic bubble memory chip and for transferring a magnetic bubble along the magnetic pattern.

The magnetic bubble memory device is capable of operating over a wider range of ambient temperature by providing for heating of the chip to be realised through heat generation caused by applying a heating current to the rotating field generation coil whilst magnetic bubble transfer control is not being performed.

For example, if the "basic" operational temperature range of a magnetic bubble memory chip is 0°C to +55°C, then the provision for heat generation in an embodiment of the present invention can allow the device to be used over the temperature range −20°C to +55°C, for example, by providing for the chip to be heated when ambient temperature falls below 0°C.

**Claims**

1. A method of driving a magnetic bubble memory device having a rotating-field generation coil (20, 23) operable to apply a rotating field to a magnetic pattern formed on a magnetic bubble memory chip of the device for transferring a magnetic bubble along the magnetic pattern, characterised in that a heating current, for heating the chip, is applied to the rotating-field generation coil (20, 23) in dependence upon temperature output data obtained from temperature detection means (14, 15) in a period in which magnetic bubble transfer control is not being performed.

2. A method as claimed in claim 1, wherein the said heating current is applied to a rotating-field generation coil (20, 23) which generates a field the direction of which matches the direction of a hold field ($H_h$) of the device.

3. A method as claimed in claim 1, wherein the said heating current is applied to a rotating-field generation coil (20, 23) which generates a field the direction of which matches the direction of a hold field ($H_h$) of the device, and a heating current is also applied to another rotating-field generation coil (23, 20) of the device in dependence upon the said temperature output data, in a period in which magnetic bubble transfer control is not being performed.

4. A method as claimed in claim 2 or 3, wherein switch means (19) are employed for connecting a rotating-field generation coil (20, 23) and a drive circuit (21, 22) for rotating-field generation during a magnetic bubble access period, and for connecting the rotating-field generation coil (20, 23) and a heating driver circuit (17, 24), for heating, during a period in which magnetic bubble access is not being performed.

5. A method as claimed in claim 4, wherein the said temperature detection means comprise a temperature detection element (14) and a temperature detection circuit (15), the operating condition of the heating driver circuit (17, 24) being controlled in dependence upon the said temperature output data obtained from the temperature detection circuit (15).

6. A method as claimed in claim 5, wherein heating current application is controlled so that a proportional heating operation is provided, proportional to difference between temperature as detected by the temperature detection circuit and the lowest operating temperature permitted for the chip.

7. A method as claimed in claim 6, wherein proportional heating is effected by one or more of the following means:—

changing heating drive pulse width in dependence upon temperature,

changing heating drive pulse period in dependence upon temperature,

changing heating current value in dependence upon temperature.

8. A method as claimed in claim 1, wherein the said heating current is applied when ambient temperature falls below the lowest operating temperature permitted for the chip.

9. Magnetic bubble memory device having a rotating-field generation coil (20, 23) operable to apply a rotating field to a magnetic pattern formed on a magnetic bubble memory chip of the device for transferring a magnetic bubble along the magnetic pattern, characterised by temperature detection means (14, 15) operable to provide temperature output data, and means operable to apply a heating current, for heating the chip, to the rotating-field generation coil in dependence upon the said temperature output data, in a period in which magnetic bubble transfer control is not being performed.

**Patentansprüche**

1. Verfahren zum Treiben einer magnetischen Blasenspeichervorrichtung mit einer ein rotierendes Feld erzeugenden Spule (20, 23), die betreibbar ist, um ein rotierendes Feld auf ein magnetisches Muster aufzubringen, das auf einem Magnetblasenspeicherchip der Vorrichtung gebildet ist, um eine Magnetblase längs dem magnetischen Muster zu transferieren, dadurch gekennzeichnet, daß ein Heizstrom, zum Heizen des Chips, der das rotierende Feld erzeugenden Spule (20, 23), in Abhängigkeit von Temperaturausgangsdaten, die von Temperaturdetektoreinrichtungen (14, 15) erhalten werden, in einer Periode zugeführt wird, in der die Magnetblasentransfersteuerung nicht durchgeführt wird.

2. Verfahren nach Anspruch 1, bei dem der genannte Heizstrom einer ein rotierendes Feld erzeugenden Spule (20, 23) zugeführt wird, die ein Feld erzeugt, dessen Richtung mit der Richtung des Haltefeldes ($H_h$) der Vorrichtung übereinstimmt.

3. Verfahren nach Anspruch 1, bei dem der genannte Heizstrom einer ein rotierendes Feld erzeugenden Spule (20, 23) zugeführt wird, die ein Feld erzeugt, dessen Richtung mit der Richtung des Haltefeldes ($H_h$) der Vorrichtung übereinstimmt, und ein Heizstrom auch einer anderen ein rotierendes Feld erzeugenden Spule (23, 20) der Vorrichtung in Abhängigkeit von den genannten Temperaturausgangsdaten in einer Periode zugeführt wird, in der die Magnetblasentransfersteuerung nicht durchgeführt wird.

4. Verfahren nach Anspruch 2 oder 3, bei dem Schalteinrichtungen (19) verwendet werden zum Verbinden einer ein rotierendes Feld erzeugenden Spule (20, 23) und einer Treiberschaltung (21, 22) zur Erzeugung des rotierenden Feldes während einer Magnetblasenzugriffsperiode, und zum Verbinden der das rotierende Feld erzeugenden Spule (20, 23) und einer heizenden Treiberschaltung (17, 24) zum Heizen während einer Periode, in der ein Magnetblasenzugriff nicht durchgeführt wird.

5. Verfahren nach Anspruch 4, bei dem die genannte Temperaturdetektoreinrichtung ein Temperaturdetektorelement (14) und eine Temperaturdetektorschaltung (15) umfaßt, und die Betriebsbedingung der heizenden Treiberschaltung (17, 24) in Abhängigkeit von den genannten Temperaturausgangsdaten gesteuert wird, die von der Temperaturdetektorschaltung erhalten werden.

6. Verfahren nach Anspruch 5, bei dem die Heizstromanwendung so gesteuert wird, daß ein Proportionalheizbetrieb vorgesehen ist, der proportional zu der Differenz zwischen der von der Temperaturdetektorschaltung detektierten Temperatur und der niedrigsten Betriebstemperatur ist, die für das Chip erlaubt ist.

7. Verfahren nach Anspruch 6, bei dem proportionale Heizung durch eine oder mehrere der folgenden Mittel bewirkt wird:—

Änderung der Heiztreiberimpulsbreite in Abhängigkeit von der Temperatur,

Änderung der Heiztreiberimpulsperiode in Abhängigkeit von der Temperatur,

Änderung des Heizstromwertes in Abhängigkeit von der Temperatur.

8. Verfahren nach Anspruch 1, bei dem der genannte Heizstrom angewendet wird, wenn die Umgebungstemperatur unter die niedrigste Betriebstemperatur fällt, die für das Chip zugelassen ist.

9. Magnetblasenspeichervorrichtung mit einer ein rotierendes Feld erzeugenden Spule (20, 23), die betriebbar ist, um ein rotierendes Feld auf ein magnetisches Muster aufzubringen, das auf einem Magnetblasenspeicherchip der Vorrichtung gebildet ist, zum Transferieren der Magnetblase längs dem magnetischen Muster, gekennzeichnet durch Temperaturdetektoreinrichtungen (14, 15), die betreibbar sind, um Temperaturausgangsdaten zu liefern, und Einrichtungen, die betreibbar sind, um zum Heizen des Chip einen Heizstrom auf die das rotierende Feld erzeugende Spule, in Abhängigkeit von den genannten Temperaturausgangsdaten, in einer Periode zu bringen, in der die Magnetblasentransfersteuerung nicht durchgeführt wird.

## Revendications

1. Procédé d'excitation d'un dispositif de mémoire à bulles magnétiques comportant une bobine de génération de champ tournant (20, 23) pouvant être mise en fonctionnement pour appliquer un champ tournant à une configuration ou dessin magnétique formé sur une puce mémoire à bulles magnétiques du dispositif pour transférer une bulle magnétique le long du dessin magnétique, caractérisé en ce qu'un courant de chauffage, servant à chauffer la puce, est appliqué à la bobine de génération de champ tournant (20, 23) en fonction d'une donnée de sortie de température obtenue d'un moyen de détection de température (14, 15) pendant une période où une commande de transfert de bulles magnétiques n'est pas réalisée.

2. Procédé selon la revendication 1, dans lequel le courant de chauffage est appliqué à une bobine de génération de champ tournant (20, 23) qui engendre un champ dont la direction correspond à la direction d'un champ de maintien (H_h) du dispositif.

3. Procédé selon la revendication 1, dans lequel le courant de chauffage est appliqué à une bobine de génération de champ tournant (20, 23) qui engendre un champ dont la direction correspond à la direction d'un champ de maintien (H_h) du dispositif, et dans lequel un courant de chauffage est également appliqué à une autre bobine de génération de champ tournant (23, 20) du dispositif en fonction de la donnée de sortie de température pendant une période où une commande de transfert de bulles magnétiques n'est pas réalisée.

4. Procédé selon l'une quelconque des revendications 2 et 3, dans lequel des moyens de commutation (19) sont mis en oeuvre pour connecter une bobine de génération de champ tournant (20, 23) et un circuit d'excitation (21, 22) pour la génération d'un champ tournant pendant une période d'accès aux bulles magnétiques, et pour connecter la bobine de génération de champ tournant (20, 23) et un circuit d'excitation de chauffage (17, 24), pour un chauffage, pendant une période où un accès aux bulles magnétiques n'est pas réalisé.

5. Procédé selon la revendication 4, dans lequel le moyen de détection de température comprend un élément de détection de température (14) et un circuit de détection de température (15), les conditions de fonctionnement du circuit d'excitation de chauffage (17, 24) étant contrôlées en fonction de la donnée de sortie de température obtenue du circuit de détection de température (15).

6. Procédé selon la revendication 5, dans lequel l'application d'un courant de chauffage est réglée, pour prévoir une opération de chauffage proportionnel, de telle sorte qu'elle soit proportionnelle à la différence entre la température telle que détectée par le circuit de détection de température et la température de fonctionnement la plus basse admise pour la puce.

7. Procédé selon la revendication 6, dans lequel le chauffage proportionnel est effectué par l'un ou plusieurs des moyens suivants:

la variation de la largeur ou durée des impulsions d'excitation de chauffage en fonction de la température,

la variation de la période des impulsions d'excitation de chauffage en fonction de la température,

la variation de la valeur du courant de chauffage en fonction de la température.

8. Procédé selon la revendication 1, dans lequel le courant de chauffage est appliqué quand la température ambiante diminue au-dessous de la température de fonctionnement la plus basse admise pour la puce.

9. Dispositif de mémoire à bulles magnétiques comportant une bobine de génération de champ tournant (20, 23) pouvant être mise en fonctionnement pour appliquer un champ tournant à un dessin magnétique formé sur une puce mémoire à bulles magnétiques du dispositif pour transférer une bulle magnétique le long du dessin magnétique, caractérisé par un moyen de détection de température (14, 15) pouvant être mis en fonctionnement pour fournir une donnée de sortie de température, et un moyen pouvant être mis en fonctionnement pour appliquer un courant de chauffage, pour chauffer la puce, à la bobine de génération de champ tournant en fonction de la donnée de sortie de température, pendant une période où une commande de transfert de bulles magnétiques n'est pas réalisée.

Fig. 1

Fig. 3

$I_x$   $Y_Y$

(a)

$H_Y$

$H_X$

(b)

Fig. 4

12

8

12'

Fig. 5

$H_B$

$\theta$

$H_0$

$Hh$

8

$\theta$

Fig. 6

$L_1$

$R_1$

Fig. 7

Fig. 8

Fig. 9

Fig. 10

Fig. 11

Fig. 12

heating period | memory access period | heating period | memory access period

device temp. $0°C$

Self-heating by X. Y coil

ambient temp.

Fig. 13

Fig. 14

Fig. 15

*Fig. 16*

Fig. 17

Fig. 18